Europäisches Patentamt

European Patent Office

Office européen des brevets

(11) Veröffentlichungsnummer: **0 213 372**
**A2**

(12) **EUROPÄISCHE PATENTANMELDUNG**

(21) Anmeldenummer: 86110228.3

(22) Anmeldetag: 24.07.86

(51) Int. Cl.⁴: **H03H 9/145** , H03H 9/02

(30) Priorität: 21.08.85 DE 3529916

(43) Veröffentlichungstag der Anmeldung:
**11.03.87 Patentblatt 87/11**

(84) Benannte Vertragsstaaten:
**DE FR GB**

(71) Anmelder: **Siemens Aktiengesellschaft Berlin und München**
**Wittelsbacherplatz 2**
**D-8000 München 2(DE)**

(72) Erfinder: **Grassl, Hans-Peter, Dr. Dipl.-Phys.**
**Obere Bahnhofstrasse 12**
**D-8011 Zorneding(DE)**

(54) **Dispersiver Interdigital-Wandler für mit akustischen Wellen arbeitenden Anordnung.**

(57) Dispersiver Wandler (100) mit seiner Bandbreite entsprechend nicht-äquidistanter Verteilung der Fingerelektroden (6, 7, 16, 17), wobei die Fingerelektroden (16, 17) des niederfrequenteren Anteils (11) des Wandlers Breite c und Abstände $d_i$ (oder $d\frac{i}{2}$ ) haben, die gleich denjenigen des höchstfrequenten Anteils (13) des Wandlers sind.

# FIG 5

EP 0 213 372 A2

## Dispersiver Interdigital-Wandler für mit akustischen Wellen arbeitenden Anordnungen.

Die Erfindung bezieht sich auf einen dispersiven Interdigital-Wandler wie im Oberbegriff des Patentanspruches 1 angegeben.

Aus dem Stand der Technik, zum Beispiel aus Convolvers mit akustischen Wellen, sind beispielsweise bekannt aus Pro. IEEE, Ultrasonics Symposium (1974), S.224 bis 227 und (1981), S. 181 bis 185 sind elektrische Filter-Resonator-Anordnungen und dergleichen bekannt, die mit akustischen Wellen arbeiten, die in einem Substrat der Anordnung in einem wenigstens oberflächennahen Bereich dieses Substrates laufen. Bekannt sind solche akustischen Wellen als Rayleigh-Wellen, Bleustein-Wellen, Love-Wellen, SSBW-Wellen, SABB-Wellen und dergleichen, die im nachfolgenden allgemein gefaßt als Oberflächenwellen bezeichnet werden - (obwohl häufig im wesentlichen nur die beiden erstgenannten Wellenarten als Oberflächenwellen im engeren Sinne bezeichnet werden).

Derartige Anordnungen mit akustischen Wellen besitzen wenigstens im Bereich der als Eingangswandler und/oder als Ausgangswandler verwendeten Interdigital-Wandler piezoelektrische Eigenschaft. Ein zu verwendender Interdigital-Wandler hat auf der Substratoberfläche parallel nebeneinander angeordnete Fingerelektroden, die im Regelfall auf zwei Kammstrukturen verteilt sind, die durch diese Finger und je eine Sammelschiene gebildet sind. Diese Kammstrukturen sind interdigital ineinander greifend. Derartige Fingerelektroden sind im Regelfall streifenförmige Metallisierungsbelegungen der Substratoberfläche.

Für die im oberflächennahen Bereich des Substrats verlaufende akustische Welle wirken solche Fingerelektroden, und zwar in einem Interdigital-Wandler unerwünschter Weise, auch als Reflektoren. Es gibt viele Vorschläge wie man derartige unerwünschte (an Fingerelektroden eines Interdigital-Wandlers auftretende) Reflexionen in ihrer störenden Wirkung herabmindern oder gar beseitigen kann.

Eine solche Maßnahme ist die bekannte Splitfinger Ausführung eines derartigen Interdigital-Wandlers, bei dem gegenüber einem einfachen Interdigital-Wandler jeder dort vorhandene einzelne Finger in zwei nebeneinanderliegend parallele Finger aufgeteilt ist, die mit gleicher Polarität elektrisch beaufschlagt werden bzw. beide mit der jeweils selben Sammelschiene verbunden sind. Im einfachen Interdigital-Wandler beträgt üblicherweise der Mittelabstand von der einen Fingerelektrode zur benachbarten, entgegengesetzt gepolten nächstfolgenden Fingerelektrode Lambda/2. Dieser Mittelabstand ist auch gleich dem (Mitten-) Abstand von einem piezoelektrischen Anregungszentrum -

(zwischen zwei einander entgegengesetzt gepolten Fingerelektroden) zum nächstbenachbarten Anregungszentrum. Diese Definition gilt im entsprechenden Sinne auch für einen als Empfangswandler verwendeten Interdigital-Wandler. Es ist üblich, diesem Mittenabstand Lamda/2 entsprechend eine Fingerelektrode Lambda/4 und den Zwischenraum zwischen zwei benachbarten Fingerelektroden ebenfalls Lambda/4 groß zu machen. Daraus ergibt sich für bei der Erfindung vorgesehene Splitfinger-Ausführung der Interdigital-Wandler (bei weiterhin einem Abstand Lambda/2 zwischen den benachbarten Anregungszentren) eine Breite Lambda/8 für eine einzelne Splitfingerelektrode und ebenfalls Lambda/8 für den Zwischenraum zwischen zwei einzelnen Splitfingerelektroden.

Eine Splitfinger-Ausführungsform eines Interdigital-Wandlers ist im wesentlichen frei von den erwähnten interditigalen Reflexionen. Dies gilt strenggenommen aber nur für die akustische Welle mit demjenigen Wert der Wellenlänge Lambda, der der Bemessung der Fingerelektroden Abstände, -breite und -zwischenraum zugrunde liegt. Dabei ist Lambda die Wellenlänge im Substrat. Für viele Anwendungsfälle, nämlich bei Resonatoren und Schmalband-Filtern ergibt sich daraus kein Problem. Anders ist dies bei solchen mit akustischen Wellen arbeitenden Anordnungen, die größere Bandbreite haben, insbesondere eine Bandbreite aufweisen, die dem Wert einer Oktave nahe kommt bzw. größer als eine (oder mehrere) Oktaven ist. Für solche Anordnungen sind dispersive Interdigital-Wandler zu verwenden, die in Einheiten von Lambda gemessene Fingerabstände, -breite, -zwischenraum und dergleichen haben, wobei für den sich über eine gewisse Länge auf dem Substrat erstreckenden Wandler in verschiedenen Längenanteilen verschieden große Lambda-Werte des vorgegebenen Bandbreitebereiches zugrundegelegt werden. Im Regelfall hat ein derartiger dispersiver Interdigital-Wandler (in einer Richtung seiner Längserstreckung gesehen) monoton abnehmende (in der Gegenrichtung zunehmende) Fingerabstände, -breite, -zwischenraum, das heißt dem einen Ende des Wandlers wird der größte Wellenlängenwert Lambda$_{max}$ der niedrigsten Frequenz des Bandbreitebereiches und dem anderen Ende der kleinste Wellenlängenwert Lambda$_{min}$ der höchsten Frequenz dieser Bandbreite zugrundegelegt.

Bereits dann, wenn Lambda$_{max}$ das zum Beispiel 1,5-fache von Lambda$_{min}$ für die vorgegebene Bandbreite beträgt, ist beim dispersiven Wandler mit größeren Störungen durch interdigitale Reflexionen zu rechnen. Ein erstes Maximum interdigitaler Reflexionen ergibt sich für Lambda$_{max}$gleich dem 2-fachen von Lambda$_{min}$ .

Aufgabe der vorliegenden Erfindung ist, Ausführungsformen für eine Splitfinger-Anordnung eines Interdigital-Wandlers anzugeben, der als dispersiver Wandler für einen im obigen Sinne größeren Bandbreitebereich bemessen bzw. vorgesehen ist, ohne daß dieser neue Wandler in wesentlichen Maße Störsignale wirksam werden läßt.

Diese Aufgabe wird mit einem dispersiven Interdigital-Wandler mit den Merkmalen des Patentanspruches 1 gelöst und weitere Ausgestaltungen und Weiterbildungen der Erfindung gehen aus den Unteransprüchen hervor.

Die oben an zweiter Stelle genannte Druckschrift zeigt zwar in Seite 187, Fig. 1 eine dispersive Anordnung mit jeweils gleichbreiten Fingern. Es handelt sich dort jedoch um keine Splitfinger-Anordnung und die gleichgroße Breite der Einfach-Finger hat nicht einmal ungewollt eine Wirkung im Sinne der Erfindung bzw. im Hinblick auf eine dort ohnehin nicht angestrebte und damit außerdem auch nicht erreichbare Unterdrückung störender Reflexionen.

Der vorliegenden Erfindung liegt die Erkenntnis zugrunde, daß in einem breitbandigen, dispersiven Interdigital-Wandler Störsignale, die auf oben beschriebenen interdigitalen Reflexionen beruhen, auftreten, obwohl für diesen Interdigital-Wandler eine Splitfinger-Anordnung gewählt worden ist. Weiter liegt der Erfindung die Erkenntnis zugrunde, daß diese Reflexionen grundsätzlich nicht beseitigt werden können und lediglich in ihren Auswirkungen herabgesetzt werden können. Dabei war zu berücksichtigen, daß gerade breitbandige, dispersive Interdigital-Wandler (parallel zur Achse der Haupt-Wellenausbreitung des Wandlers) eine relativ große Anzahl aufeinanderfolgender Fingerelektroden haben, das heißt, die Anzahl der Reflexionsstellen für interdigitale Reflexionen groß ist im Vergleich zu einem schmalbandigen Wandler in üblicher Ausführungsform desselben. Bei der Erfindung ist vorgesehen, in den Anteilen des betreffenden Wandlers, die auf den niederfrequenteren Bereich der vorgegebenen Bandbreite abgestimmt sind, Abmessungen der Breite der Fingerelektroden vorzusehen, die der entsprechenden Abmessung der Fingerelektroden desjenigen Anteils (des Wandlers) entsprechen, der für den höchstfrequenten Anteil des Bandbreitenbereiches bestimmt ist. Eine weitere Maßnahme der Erfindung ist, die Bemessung der damit (im niederfrequenten Anteil des Wandlers) sich ergebenden veränderten Abstände bzw. Zwischenräume zwischen den Fingerelektroden richtig zu bestimmen und richtig aufzuteilen bzw. zu verteilen.

Es sei darauf hingewiesen, daß die Erfindung auch für fingerverdünnte Interdigital-Wandler zu verwenden ist, obwohl die Fingerverdünnung für dispersive Wandler geringere Bedeutung hat, als dies für vorzugsweise besonders schmalbandige Wandler (mit großer Länge) der Fall ist.

Von besonderer Bedeutung ist die Anwendung der Erfindung, das heißt die Verwendung eines nach der Erfindung ausgebildeten Interdigital-Wandlers, für Oberflächenwellen-Convolver-Anordnungen, und insbesondere dabei für solche Convolver-Anordnungen mit kompensierter Selbstfaltung. Für Convolver-Anordnungen hat die große Bandbreite besondere Bedeutung, jedoch werden breitbandige Interdigital-Wandler auch in zahlreichen anderen Anwendungsfällen von mit akustischen Wellen arbeitenden Anordnungen benötigt.

Weitere Erläuterungen der Erfindung gehen aus der nachfolgenden, anhand der Figuren gegebenen Beschreibung hervor.

Figur 1 zeigt einen dispersiven Interdigital-Wandler in Splitfinger-Anordnung, wobei dieser Wandler Teil einer im übrigen nicht detailliert ausgeführten, mit akustischen Wellen arbeitenden Anordnung ist. Diese Figur zeigt bekannten Stand der Technik.

Figur 2 zeigt in schematischer Darstellung und im Schnitt Asschnitte einer Seitenansicht eines bekannten dispersiven Interdigital-Wandlers der Figur 1.

Figur 3 zeigt vergleichsweise zur Figur 2 eine schematische Darstellung eines erfindungsgemäß ausgeführten dispersiven Interdigital-Wandlers, und zwar eine erste Erfindungsvariante.

Figur 4 zeigt eine vergleichsweise zur Figur 3 zweite Erfindungsvariante und

Figur 5 zeigt eine (der Figur 1 vergleichbare) Ansicht eines erfindungsgemäßen Wandlers nach der Variante der Figur 3.

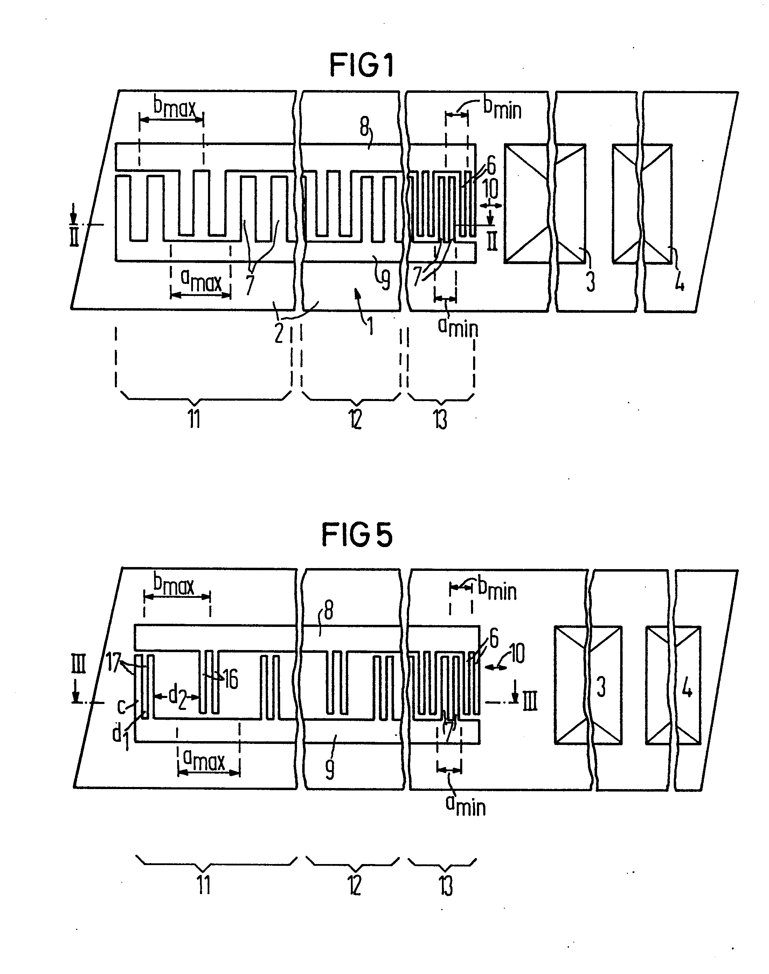

In Figur 1 ist mit 1 ein dispersiver Interdigital-Wandler dargestellt, der sich auf der Oberfläche eines Substrats 2 befindet. Mit 3 und 4 sind weitere, auf der Substratoberfläche vorhandene Strukturen für akustische Wellen bezeichnet, wobei zum Beispiel die Struktur 3 die Integrationselektrode (und Strahlkompressor-Anordnungen) und die Struktur 4 der (Ausgangs-) Interdigital-Wandler einer Convolveranordnung sein kann.

Mit 6 und 7 sind einzelne Fingerelektroden des Wandlers 1 und mit 8 und 9 dessen Sammelschienen (bus-bars) bezeichnet. Entsprechend der Splitfinger-Anordnung sind jeweils zwei benachbarte Fingerelektroden 6 mit der einen Sammelschiene und jeweils zwei benachbarte Fingerelektroden 7 mit der anderen (entgegengesetzt gepolten) Sammelschiene 9 verbunden. Wie aus der Figur 1 ersichtlich, nehmen Elektrodenfingerbreite und -zwischenräume (in der Figur 1) von links nach rechts parallel zur Haupt-Wellenausbreitungsrichtung 10 des Wandlers 1 ab. Entsprechend abnehmend ist der Abstand $a_{max}$ zu $a_{min}$ worin a (gleich Lambda/2) der Abstand der (gestrichelt eingezeichneten) Linien der beim (Sende)-Wandler auftretenden Anregungsschwerpunkte ist. Diese Anregungsschwerpunkte liegen zwischen entgegengesetzt gepolten Fingern 6 und 7. Mit b ist der entsprechende Mittelabstand benachbarter, entgegengesetzt gepolter Splitfinger-Paare bezeichnet. Der in Figur 1 mit 11 angedeutete (Längen-)Anteil des Wandlers 1 ist auf den Bereich der niedrigen Frequenzen (größte Wellenlänge $Lambda_{max}$) der vorgegebenen Bandbreite abgestimmt. Der Längenanteil 12 entspricht einem mittleren Frequenzbereich und der Längenanteil 13 entspricht dem hochfrequenten Anteil (mit $Lambda_{min}$) des Wandlers 1. Diese Darstellung der Figur 1 bzw. des Wandlers 1 ist lediglich prinipieller Art, insbesondere hinsichtlich der Anteile 11 bis 13, der Anzahl der Fingerelektroden des ganzen Wandlers und dergleichen.

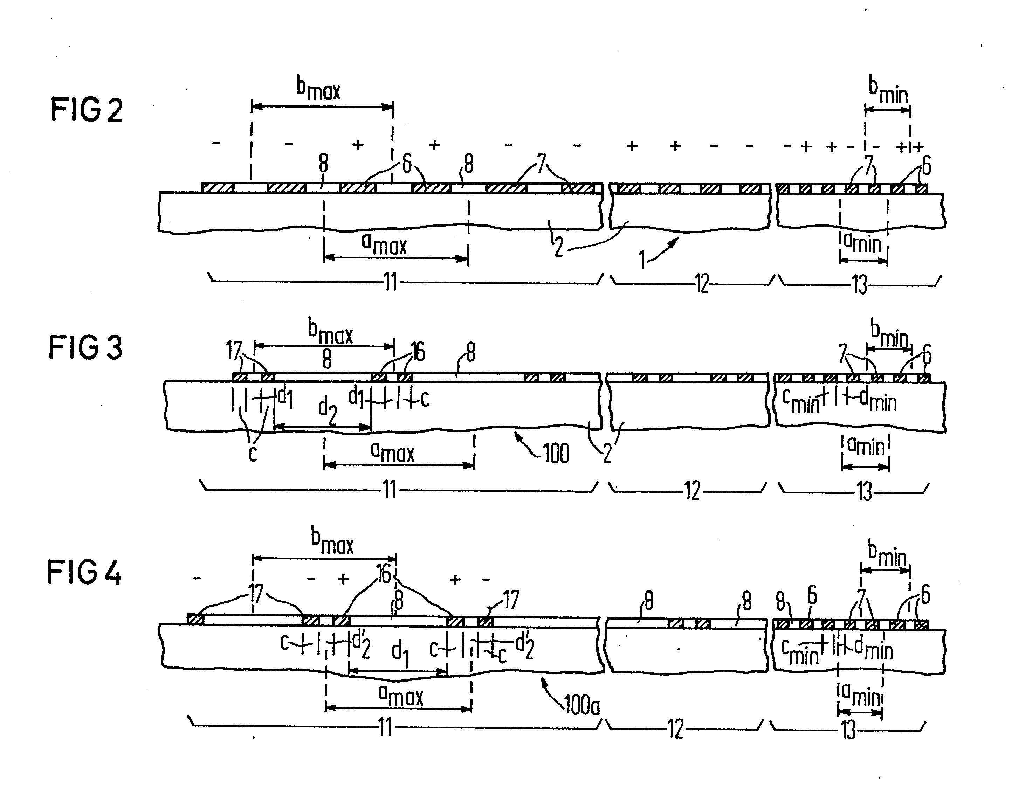

Figur 2 zeigt die Fingerelektroden 6 und 7 und das Substrat 2 im Schnitt. Nicht geschnitten ist im Hintergrund die Sammelschiene 8 dargestellt. Für diese und die mit ihr verbundenen Fingerelektroden 6 ist die (augenblickliche) Polarität + angenommen. Die Anteile für niedrige (11), mittlere (12) und hohe Frequenz (13) der Fingerelektrodenanordnung 6, 7 des Wandlers 1 entsprechen der Figur 1. Mit c ist die jeweilige Breite der einzelnen Fingerelektroden 7, 8 und mit d der Zwischenraum zwischen zwei benachbarten Fingern 6 und zwei benachbarten Fingern 6 und 7 bezeichnet. Wie ersichtlich sind die Abmessungen a, b, c und d über die Länge des Wandlers 1 hinweg nicht konstant. Dies entspricht der vorgesehenen Dispersion des Wandlers 1.

Figur 3 zeigt eine erste Variante der erfindungsgemäßen Ausführungsform eines Interdigital-Wandlers 100. Der Anteil 13 des Wandlers 100 nach Figur 3 ist übereinstimmend mit dem Anteil 13 eines bekannten Wandlers nach den Figuren 1 und 2. Es ist dies wiederum derjenige Anteil des Wandlers 100 der auf die hohen Frequenzen bzw. auf die Wellenlänge $Lambda_{min}$ des vorgegebenen Bandbreitebereiches abgestimmt ist. Mit $a_{min}$ ist wieder der Abstand ($Lambda_{min}$/2) zwischen zwei benachbarten Anregungszentren angegeben. Der Abstand $b_{min}$ ist wiederum der Mittenabstand zwischen zwei benachbarten Splitfinger-Paaren mit entgegengesetzter Polarität, $c_{min}$ ist die Breite der Fingerelektroden und $d_{min}$ der Zwischenraum zwischen zwei benachbarten Fingerelektroden gleicher Polarität bzw. entgegengesetzter Polarität. Diese Bemessungen gelten im übrigen auch für den Anteil 13 der zweiten Variante der Erfindung nach Figur 4.

In den Anteilen 11 und 12 der Figur 3 ist das gegenüber dem Stand der Technik nach Figuren 1 und 2 neue der Erfindung zu erkennen. Die Fingerbreite ist mit c, der Zwischenraum zwischen zwei Fingerelektroden eines Splitfinger-Paares, das heißt zwischen zwei Fingerelektroden gleicher Polarität ist mit $d_1$ bezeichnet. Mit $d_2$ ist der (von der Abmessung $d_1$ erheblich abweichende Zwischenraum zwischen zwei benachbarten Fingerelektroden 16 und 17 mit verschiedener Polarität bezeichnet. Wesentlich für die Erfindung ist, daß hier die Breite c der Fingerelektroden 16, 17 gleich dem Wert $c_{min}$ oder nicht wesentlich größer, maximal nicht mehr als etwa 1,5 mal größer als $c_{min}$ ist.

Die Breite $b_1$ des Zwischenraums zwischen zwei Elektrodenfingern 16, 17 eines Splitfinger-Paares entsprechend der Variante der Figur 3 der Erfindung ebenfalls gleich $d_{min}$ oder wenigstens nicht wesentlich größer (etwa nicht mehr als 1,5-fach größer) als $d_{min}$ bemessen. Der Vollständigkeit halber sei noch darauf hingewiesen, daß c und $d_1$ auch kleiner als $c_{min}$ bzw. $d_{min}$ bemessen werden können, jedoch bedingt dies erhöhten technologischen Aufwand. Zu bevorzugen ist $c_{min} = d_{min} = c = d_1$.

Bei dem erfindungsgemäßen Wandler 100 sind ebenso wie zwangsläufig für den Anteil 13 in für die hohen Frequenzen auch für den Anteil 11 für die niedrigsten Frequenzen und entsprechend für alle dazwischenliegenden Anteile, wie den Anteil 12, für dazwischenliegende Frequenzen, Abmessungen der Breite c für die Fingerelektroden 16, 17 und Abstände $d_1$ zwischen gleichgepolten Elektrodenfingern 16 bzw. 17 gewählt. Zwangsläufig ist die Abmessung $d_2$ vergleichsweise zum Stand der Technik wesentlich größer, weil die Bedingung gilt: $b_{max} = d_2 + 2 \cdot c + d_1$, worin $b_{max} = Lambda_{max}/2$ ist.

Figur 4 zeigt einen erfindungsgemäßen Wandler 100a. Soweit zum Wandler 100a nichts gegenteiliges ausgesagt ist, gelten für diesen Wandler 100a die Ausführungen zum Wandler 100 der Figur 3. Unterschiedlich zueinander sind die Wandler 100 und 100a darin, daß die Fingerelektroden 16 und 17 beim Wandler 100a anders verteilt sind als beim Wandler 100. Diesen beiden Varianten liegt jedoch dasselbe Prinzip zugrunde, nämlich die Breite c der Fingerelektroden wie zur Figur 3 beschrieben zu bemessen. Beim Wandler 100a wird jedoch die Breite $b_2'$ sinngemäß entsprechend der Abmessung $d_1$ des Wandlers 100 gewählt. Das heißt, daß beim Wandler 100a jeweils ein Elektrodenfinger 16 der einen Polarität dicht benachbart einem Elektrodenfinger 17 der anderen Polarität liegt. Entsprechend groß ist die Abmessung $d_i$' des Zwischenraums zwischen den Fingerelektroden 16 einerseits und den Fingerelektroden 17 andererseits des jeweiligen SplitfingerPaares. Auch hier gilt wieder ($b_{max}$ = ) $a_{max}$ = b'$_i$ + 2 . c + $d_z$' = Lambda$_{max}$/2. Auch für den Anteil 12 des Wandlers 100a nach Figur 4 gilt das zum Anteil 12 des Wandlers 100 oben Ausgeführte.

Ein erfindungsgemäßer Wandler kann über seine Länge hinweg auch anteilsweise entsprechend der Variante des Wandlers 100 und anteilsweise entsprechend der Variante des Wandlers 100a ausgeführt sein. Zum Beispiel kann der Anteil 11 entsprechend dem Anteil 11 der Figur 3 und ein Anteil 12 entsprechend der Figur 4 ausgeführt sein, wobei der Anteil 13 immer wenigstens im wesentlichen so ausgeführt ist, wie dies zu den Figuren 3, 4 und der Figur 2 beschrieben ist.

Figur 5 zeigt den Wandler 100 in Aufsicht. Einzelheiten der Figur 5 gehen aus der vorangehenden Beschreibung hervor.

## Ansprüche

1. Dispersiver Interdigital-Wandler für Anordnungen mit akustischen Wellen,

mit Splitfinger-Anordnung,.

mit einer derartigen Verteilung der Fingerelektroden und Bemessung der durch die Fingerverteilung gegebenen Anregungszentren, daß dieser dispersive Interdigital-Wandler eine Bandbreite hat, die an einer Oktave heranreicht oder eine oder mehrere Oktaven umfaßt,

wobei in dem für die hohen Frequenzen - (Lambda$_{min}$) bemessenen Anteil (13) dieses Interdigital-Wandlers der Abstand zwischen benachbarten Anregungszentren (a = Lambda$_{min}$/2) und die Breite der Fingerelektroden (a = Lambda$_{min}$/8) und der Zwischenraum jeglicher benachbarter Finger (d = Lambda$_{min}$/8) diesen höchsten Frequenzen entsprechend bemessen sind und

in den übrigen Anteilen (11, 12) des Interdigital-Wandlers die entsprechenden Bemessungen auf dagegen niedrigere Frequenzen der Bandbreite abgestimmt gewählt sind,

**gekennzeichnet dadurch,**

-daß bei der jeweiligen Frequenz angepaßt bemessenen Abstan a benachbarter Anregungszentren voneinander und Abstand b zwischen benachbarten Fingerschwerpunkten der einander entgegengesetzt gepolten Splitfinger-Paare (16 und 17)

-die Breite c der einzelnen Fingerelektroden (16, 17) und der Zwischenraum d, zwischen den einzelnen Splitfingerelektroden (16 bzw. 17) der einzelnen Splitfinger Elektrodenpaare wenigstens angenähert gleich denjenigen Fingerbreite-und Zwischenraum-Abmessungen ($c_{min}$, $d_{min}$) sind, die in dem für die hohen Frequenzen der Bandbreite vorgesehenen Anteil 13 des Interdigital-Wandlers 100 vorliegen.

2. Dispersiver Interdigital-Wandler für Anordnungen mit akustischen Wellen,

mit Splitfinger-Anordnung,

mit einer derartigen Verteilung der Fingerelektroden und Bemessung der durch die Fingerverteilung gegebenen Anregungszentren, daß dieser dispersive Interdigital-Wandler eine Bandbreite hat, die an einer Oktave heranreicht oder eine oder mehrere Oktaven umfaßt,

wobei in dem für die hohen Frequenzen - (Lambda$_{min}$) bemessenen Anteil (13) dieses Interdigital-Wandlers der Abstand zwischen benachbarten Anregungszentren (a = Lambda$_{min}$/2) und die Breite der Fingerelektroden (a = Lamdda$_{min}$/8) und der Zwischenraum jeglicher benachbarter Finger (d = Lamdba$_{min}$/8) diesen höchsten Frequenzen entsprechend bemssen sind und

in den übrigen Anteilen (11, 12) des Interdigital-Wandlers die entsprechenden Bemessungen auf dagegen niedrigere Frequenzen der Bandbreite abgestimmt gewählt sind,

**gekennzeichnet dadurch,**

-daß bei der jeweiligen Frequenz angepaßt bemessenen Abstand a benachbarter Anregungszentren voneinander und Abstand b zwischen benachbarten Fingerschwerpunkten der einander entgegengesetzt gepolten Splitfinger-Paare (16 und 17)

-die Breite c der einzelnen Fingerelektroden (16, 17) und der Zwischenraum die zwischen benachbarten Splitfingerelektroden (16, 17) entgegengesetzter Polarität wenigstens angenähert gleich denjenigen Fingerbreite-und -zwischenraum-Abmessungen (C $_{min}$; $d_{min}$) sind, die in den für die hohen Frequenzen der Bandbreite vorgesehenen Anteil 13 des Interdigital-Wandlers (100a) vorliegen.

3. Wandler nach Anspruch 1, **gekennzeichnet dadurch,** daß die Breite c der Fingerelektroden 16 bzw. 17 und der Zwischenraum (b$_i$) zwischen benachbarten Fingerelektroden 16 oder 17 eines jeweiligen Splitfinger-Paares nicht größer als das 1,5 fache der entsprechenden Abmessungen der Fingerelektroden des für die hohen Frequenzen angepaßten Anteils 13 des Wandlers 100 ist.

4. Wandler nach Anspruch 2, **gekennzeichnet dadurch**, daß die Breite c der Fingerelektroden und der Zwischenraum $d_2'$ nicht größer als das 1,5 fache der entsprechenden Abmessungen $c_{min}$, $d_{min}$) des für die hohen Frequenzen bemessenen Anteils 13 des Wandlers 100a ist.

FIG 1

FIG 5

FIG 2

FIG 3

FIG 4